# EUROPEAN PATENT APPLICATION

(11) **EP 4 345 899 A1**
(43) Date of publication of application: **03.04.2024**
(21) Application number: 23192386.3
(22) Date of filing: 21.08.2023
(51) Int. Cl.: H01L 27/02, H01L 29/74, H01L 29/87

(54) **ELECTRO-STATIC DISCHARGE PROTECTION DEVICE**

(30) Priority: 27.09.2022 KR 20220122746; 30.07.2023 US 202318361892
(71) Applicant: Samsung Electronics Co., Ltd., Suwon-si, Gyeonggi-do 16677 (KR)
(72) Inventor: SONG, Jongkyu, 16677 Suwon-si, Gyeonggi-do (KR); KIM, Minho, 16677 Suwon-si, Gyeonggi-do (KR); HEO, Jin, 16677 Suwon-si, Gyeonggi-do (KR); DO, Kyoungil, 16677 Suwon-si, Gyeonggi-do (KR); SONG, Jooyoung, 16677 Suwon-si, Gyeonggi-do (KR); JEON, Chanhee, 16677 Suwon-si, Gyeonggi-do (KR)
(74) Representative: Kuhnen & Wacker Patent- und Rechtsanwaltsbüro PartG mbB

(57) **Abstract**

An electro-static discharge protection device includes a substrate that includes a first well that has a first conductive type and a second well that has a second conductive type, and first to eighth diffusion regions formed on the first well and the second well. At least a portion of the diffusion regions formed in the first well are connected to a first electrode, and at least a portion of diffusion regions formed in a second well are connected to a second electrode. The contact between one of diffusion regions formed in the first well and an N well forms a trigger diode. A junction between one of diffusion regions formed in a second well and a P well forms a trigger diode. The trigger diodes are electrically connected to each other.

## Description

### CROSS-REFERENCE TO RELATED APPLICATIONS

This application claims priority under 35 U.S.C. § 119 from Korean Patent Application No. 10-2022-0122746, filed on September 27, 2022 in the Korean Intellectual Property Office, the contents of which are herein incorporated by reference in their entirety.

### TECHNICAL FIELD

Embodiments of the present disclosure are directed to an electro-static discharge protection device based on a thyristor.

### DISCUSSION OF THE RELATED ART

An electro-static discharge (ESD) protection device based on a silicon controlled rectifier (SCR) (or a thyristor) is triggered by a reverse-breakdown voltage between an N well and a P well, and has high trigger voltage. In addition, a typical electro-static protection device based on a SCR has a low-level holding voltage due to an internal parasitic bipolar junction transistor (BJT).

A high-level trigger voltage can destroy devices, such as the transistors that constitute electronic devices, and a low-level holding voltage can cause a latch-up phenomenon in which an ESD protection device operates even after terminating the input of the ESD voltage. In other words, as a window of a section, such as a snapback section, in which the value of the voltage decreases after triggering the ESD protection device, is widened, the reliability of the electronic device can be degraded.

Accordingly, designing an ESD protection device that efficiently protects an electronic device by decreasing the level of a trigger voltage and increasing the level of a holding voltage to prevent the latch-up phenomenon after ESD voltage input is terminated is desired to protect the reliability of the electronic device.

### SUMMARY

Embodiments of the present disclosure provide an electro-static discharge protection device based on a thyristor that can effectively protect an electronic device by lowering the level of a trigger voltage.

According to an embodiment, an electro-static discharge (ESD) protection device includes a substrate that includes a first well that has a first conductive type and a second well that has a second conductive type, a first diffusion region that has the first conductive type and a second diffusion region that has the second conductive type, in which the first diffusion region and the second diffusion region are formed on the first well and connected to a first electrode, a third diffusion region that has the first conductive type and a fourth diffusion region that has the second conductive type, in which the third diffusion region and the fourth diffusion region are formed on the second well and connected to a second electrode, a fifth diffusion region that has the first conductive type and that is formed on the first well and is adjacent to the second diffusion region, a sixth diffusion region that has the second conductive type and that is formed on the second well and is adjacent to the third diffusion region, a seventh diffusion region that has the second conductive type and that is formed on the first well and is adjacent to the first diffusion region, and an eighth diffusion region that has the first conductive type and that is formed on the second well and is adjacent to the sixth diffusion region. The seventh diffusion region and the eighth diffusion region are electrically connected to each other.

According to an embodiment, an electro-static discharge (ESD) protection device includes a substrate that includes a first well that has a first conductive type, a second well that has the first conductive type, and a third well that has a second conductive type, a first diffusion region that has the first conductive type and a second diffusion region that has the second conductive type, in which the first diffusion region and the second diffusion region are formed on the first well and connected to a first electrode, a third diffusion region that has the first conductive type and a fourth diffusion region that has the second conductive type, in which the third diffusion region and the fourth diffusion region are formed on the second well and connected to a second electrode, a fifth diffusion region that has the first conductive type and that is formed on the first well and is adjacent to the second diffusion region, a sixth diffusion region that has the second conductive type and that is formed on the second well and is adjacent to the third diffusion region, a seventh diffusion region that has the second conductive type and that is formed on the first well and is adjacent to the first diffusion region, and an eighth diffusion region that has the first conductive type and that is formed on the third well. The seventh diffusion region and the eighth diffusion region are electrically connected to each other.

According to an embodiment, an electro-static discharge (ESD) protection device includes a substrate that includes a first well that has a first conductive type, a second well that has the first conductive type, and a third well that has a second conductive type, a first diffusion region that has the first conductive type and a second diffusion region that has the second conductive type, in which the first diffusion region and the second diffusion region are formed on the first well and connected to a first electrode, a third diffusion region that has the first conductive type and a fourth diffusion region that has the second conductive type, in which the third diffusion region and the fourth diffusion region are formed on the third well and connected to a second electrode, a fifth diffusion region that has the first conductive type and that is formed on the third well and is adjacent to the second diffusion region, a sixth diffusion region that has the second conductive type and that is formed on the third well and is adjacent to the third diffusion region, a seventh diffusion region that has the second conductive type and that is formed on the second well, an eighth diffusion region that has the first conductive type and that is formed on the third well, and at least one diode that electrically connects the seventh diffusion region and the eighth diffusion region.

### BRIEF DESCRIPTION OF THE FIGURES

FIG. 1 is a plan view of an ESD protection device according to an embodiment of the present disclosure.
FIG. 2 is a cross-sectional view taken along line A-A' of an ESD protection device of FIG. 1.
FIG. 3 is an equivalent circuit diagram of an ESD protection device of FIG. 2.
FIG. 4 illustrates current-voltage curves of an ESD protection device when trigger diodes are electrically connected to each other according to an embodiment of the present disclosure, and an ESD protection device when trigger diodes are not electrically connected to each other.
FIG. 5 is a cross-sectional view taken along line A-A' of an ESD protection device of FIG. 1.
FIG. 6 is a cross-sectional view taken along line A-A' of an ESD protection device of FIG. 1.
FIG. 7 is a cross-sectional view taken along line A-A' of an ESD protection apparatus of FIG. 1.
FIG. 8 is an equivalent circuit diagram of an ESD protection device of FIG. 7.
FIG. 9 is a plan view of an ESD protection device according to an embodiment of the present disclosure.
FIG. 10 is a cross-sectional view taken along line A-A' of an ESD protection device of FIG. 9.
FIG. 11 is an equivalent circuit diagram of an ESD protection device of FIG. 10.
FIG. 12 is a plan view of an ESD protection device according to an embodiment of the present disclosure.
FIG. 13 is a cross-sectional view taken along line A-A' of an ESD protection device of FIG. 12.
FIG. 14 is a plan view of an ESD protection device according to an embodiment of the present disclosure.
FIG. 15 is a cross-sectional view taken along line A-A' of an ESD protection device of FIG. 14.
FIG. 16 is a cross-sectional view taken along line A-A' of an ESD protection device of FIG. 14.
FIG. 17 illustrates an electronic device that includes an ESD protection device according to an embodiment of the present disclosure.
FIG. 18 illustrates a system that includes an ESD protection device according to an embodiment of the present disclosure.

### DETAILED DESCRIPTION

Hereinafter, embodiments of the present disclosure are described in detail so that one of ordinary skill in the art can easily implement the present disclosure.

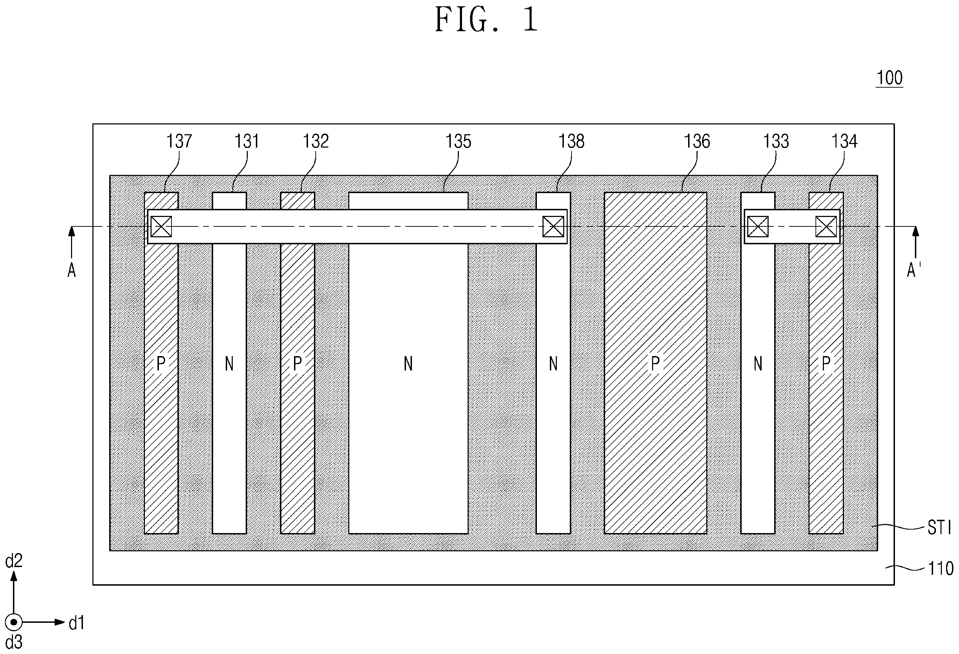

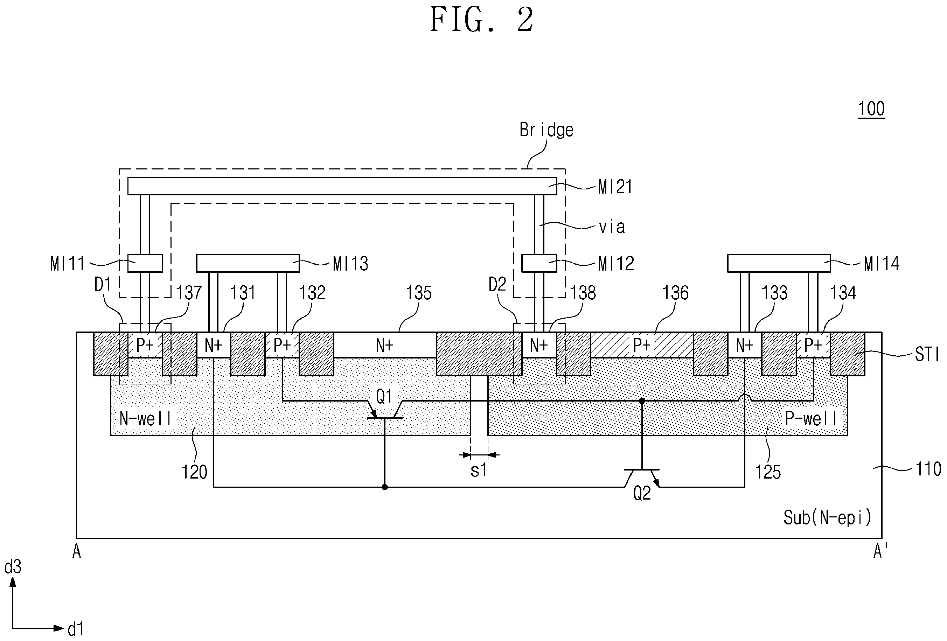

FIG. 1 is a plan view of an electro-static discharge protection device 100 according to an embodiment of the present disclosure. FIG. 2 is a cross-sectional view taken along line A-A' of the electro-static discharge protection device 100 of FIG. 1.

Referring to FIGS. 1 and 2, in an embodiment, the electro-static discharge (ESD) protection device 100 includes a substrate 110, an N well 120, a P well 125, a first diffusion region 131, a second diffusion region 132, a third diffusion region 133, a fourth diffusion region 134, a fifth diffusion region 135, a sixth diffusion region 136, a seventh diffusion region 137, an eighth diffusion region 138, and a metal interconnection that electrically connects the seventh diffusion region 137 to the eighth diffusion region 138.

In an embodiment, the substrate 110 is an N type epitaxial layer (N-epi) that has a low concentration of N-type dopants. For example, an epitaxial layer is formed on a separate substrate doped with P type dopants or N type dopants. Alternatively, in an embodiment, the substrate 110is doped with P type dopants at a low concentration.

The N well 120 and the P well 125 are formed on the substrate 110. The N well 120 and the P well 125 extend in a second direction d2 and are spaced apart from each other in a first direction d1 that crosses the second direction d2. The N well 120 is doped with a low concentration of N dopants, and the P well 125 is doped with a low concentration of P dopants. For example, the dopant concentration of the N well 120 and the dopant concentration of the P well 125 are lower than the dopant concentration of the substrate 110.

According to an embodiment, the N well 120 and the P well 125 are spaced apart from each other in the first direction d1. For example, since the N well 120 and the P well 125 are spaced apart from each other by a distance s1 in the first direction, the value of the trigger voltage of the ESD protection device 100 increases as compared to a case where the N well 120 and the P well 125 are in contact with each other.

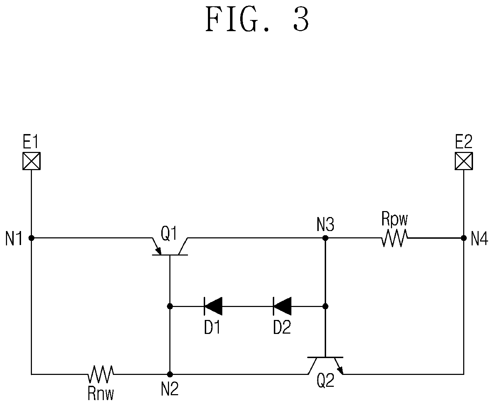

The first diffusion region 131 and the second diffusion region 132 are formed on the N well 120. The first diffusion region 131 and the second diffusion region 132 extend in the second direction d2 and are spaced apart from each other in the first direction d1. The first diffusion region 131 and the second diffusion region 132 are electrically isolated from each other by a shallow trench isolation (STI) layer. The first diffusion region 131 is doped with N type dopants to have N type conductivity, and the second diffusion region 132 is doped with P type dopants to have P type conductivity. For example, the dopant concentration of the first diffusion region 131 and the dopant concentration of the second diffusion region 132 are higher than the dopant concentration of the N well 120. The first diffusion region 131 and the second diffusion region 132 are electrically connected to each other through a metal interconnection MI13 and vias. For example, the metal interconnection MI13 is connected to a first electrode E1 (see FIG. 3), and the first electrode E1 is an anode electrode that receives an electro-static discharge (ESD) voltage.

The third diffusion region 133 and the fourth diffusion region 134 are formed on the P well 125. The third diffusion region 133 and the fourth diffusion region 134 extend in the second direction d2 and are adjacent to each other in the first direction d1. The third diffusion region 133 and the fourth diffusion region 134 are electrically isolated from each other by a shallow trench isolation (STI) layer. The third diffusion region 133 is doped with N type dopants, and the fourth diffusion region 134 is doped with P type dopants. For example, the dopant concentration of the third diffusion region 133 and the dopant concentration of the fourth diffusion region 134 are higher than the dopant concentration of the P well 125. The third diffusion region 133 and the fourth diffusion region 134 are electrically connected to each other through a metal interconnection MI14 and vias. For example, the metal interconnection MI14 is connected to a second electrode E2 (see FIG. 3), and the second electrode is a cathode electrode connected to a ground node.

The fifth diffusion region 135 is formed on the N well 120. The fifth diffusion region 135 extends in the second direction d2, and is adjacent to the second diffusion region 132 in the first direction d1. The second diffusion region 132 and the fifth diffusion region 135 are electrically isolated from each other by a shallow trench isolation (STI) layer. The fifth diffusion region 135 is doped with N type dopants. For example, the dopant concentration of the fifth diffusion region 135 is higher than the dopant concentration of the N well 120.

The sixth diffusion region 136 is formed on the N well 125. The sixth diffusion region 136 extends in the second direction d2, and is adjacent to the third diffusion region 133 in the first direction d1. The third diffusion region 133 and the sixth diffusion region 136 are electrically isolated from each other by a shallow trench isolation (STI) layer. The sixth diffusion region 136 is doped with P type dopants. For example, the dopant concentration of the sixth diffusion region 136 is higher than the dopant concentration of the P well 125.

According to an embodiment, a length of the fifth diffusion region 135 in the first direction d1 and a length of the sixth diffusion region 136 in the first direction d1 are preset to determine a holding voltage of the ESD protection device 100. For example, as the length of the fifth diffusion region 135 in the first direction d1 and the length of the sixth diffusion region 136 in the first direction d1 increase, the value of the holding voltage of the ESD protection device 100 increases. On the other hand, as the length of the fifth diffusion region 135 in the first direction d1 and the length of the sixth diffusion region 136 in the first direction d1 decrease, the value of the holding voltage of the ESD protection device decreases.

The seventh diffusion region 137 is formed on the N well 120. The seventh diffusion region 137 extends in the second direction d2, and is adjacent to the first diffusion region 131 in the first direction d1. The first diffusion region 131 and the seventh diffusion region 137 are electrically isolated from each other by a shallow trench isolation (STI) layer. The seventh diffusion region 137 is doped with P type dopants. For example, the dopant concentration of the seventh diffusion region 137 is higher than the dopant concentration of the N well 120.

The eighth diffusion region 138 is formed on the P well 125. The eighth diffusion region 138 extends in the second direction d2, and is adjacent to the sixth diffusion region 136 in the first direction d1. The sixth diffusion region 136 and the eighth diffusion region 138 are electrically isolated from each other by a shallow trench isolation (STI) layer. The eighth diffusion region 138 is doped with N type dopants. For example, the dopant concentration of the eighth diffusion region 138 is higher than the dopant concentration of the P well 125.

According to an embodiment, metal interconnections MI11, MI12, MI13, and MI14 are formed on the substrate 110. For example, the metal interconnections MI11, MI12, MI13, and MI14 are formed on a first layer on the substrate 110, and are electrically connected to diffusion regions on the substrate 110 through vias. In addition, a metal interconnection MI21 is formed on a second layer on the first layer on which the metal wirings MI11, MI12, MI13, and MI14 are formed. The metal interconnection MI21 is connected to one or more of the metal interconnection formed in the first layer through vias.

According to an embodiment, the seventh diffusion region 137 and the eighth diffusion region 138 are electrically connected to each other through the metal interconnections and vias. Accordingly, a diode D1 is formed through a PN junction between the seventh diffusion region 137 and the N well 120, and a diode D2 is formed through the PN junction between the P well 125 and the eighth diffusion region 138. The diodes D1 and D2 are electrically connected to each other. The diodes D1 and D2 may be referred to as trigger diodes.

However, embodiments are not necessarily limited to a configuration described above, and in other embodiments, trigger diodes are electrically connected to each other through various electrical interconnections that different from those shown in FIG. 2.

FIG. 3 is an equivalent circuit diagram of the ESD protection device 100 of FIG. 2.

Referring to FIGS. 2 and 3, in an embodiment, an electrode connected to the metal interconnection MI13 is the first electrode E1, and an electrode connected to the metal interconnection MI14 is the second electrode E2.

The second diffusion region 132, the N well 120, and the P well 125 constitute a PNP transistor Q1, and the N well 120, the P well 125, and the third diffusion region 133 constitute an NPN transistor Q2.

As described above, the seventh diffusion region 137 and the N well 120 constitute the trigger diode D1, and the P well 125 and the eighth diffusion region 138 constitute the trigger diode D2. The diodes D1 and D2 are connected to each other between a node N2 and a node N3. A base, an emitter, and a collector of the transistor Q1 are connected to the nodes N2, N1, and N3, respectively, and the base, emitter, and collector of the transistor Q2 are connected to the nodes N3, N2, and N4, respectively.

A resistor Rnw that indicates the resistance of the N well 120 is connected between the node N1 and the node N2. A resistor Rpw that indicates the resistance of the P well 125 is connected to the node N3 and the node N4.

An operation of the ESD protection device 100 will be described below with reference to FIGS. 2 and 3, on the assumption that the trigger diodes D1 and D2 of an embodiment of the present disclosure are not electrically connected to each other.

When an ESD voltage is received through the first electrode E1, the potential of the N well 120 increases. Accordingly, the N well 120 and the P well 125 become reverse-biased, so that a depletion region is formed. When the electric field formed in the depletion region exceeds a threshold value as an ESD current continues to be received, a reverse breakdown, such as an avalanche breakdown, can occur between the N well 120 and the P well 125. In addition, an electron-hole pair (EHP) is generated within the depletion region, and a hole current is generated by the generated carriers, e.g., the EHPs.

The hole current first flows through the internal resistance Rwp of the P well 125 and causes a voltage drop. For example, when the voltage of the P well 125 turns on the diode due to the PN junction between the P well 125 and the third diffusion region 133, the transistor Q2 is turned on. In addition, the hole current flows through the internal resistance Rnw of the N well 120 and causes a voltage drop. For example, when the voltage of the N well 120 turns on the diode due to the PN junction between the second diffusion region 132 and the N well 120, the transistor Q1 is turned on.

For example, two parasitic transistors Q1 and Q2 provide a base current to each other and maintain a positive feedback operation, such that the ESD protection device 100 enters a latch mode. A current discharge path forms through the transistors Q1 and Q2 in the latch mode of the ESD protection device 100, such that the ESD current is discharged through the second electrode E2.

As described above, in the ESD protection device 100 without trigger diodes D1 and D2, or trigger diodes D1, D2 that are not electrically connected to each other, the threshold value of the ESD voltage for reverse breakdown between the N well 120 and the P well 125 has a greater value. Accordingly, since the value of a trigger voltage for turning on the NPN transistor Q2 has a greater value, the value of the trigger voltage might not protect the electronic device.

The operation of the ESD protection device 100 when the trigger diodes D1 and D2 are electrically connected to each other will be described with reference to FIGS. 2 and 3.

When an ESD voltage is received through the first electrode E1, the potential of the N well 120 increases. Therefore, a reverse bias is applied to a diode that includes the seventh diffusion region 137 and the N well 120. When the applied reverse bias exceeds the threshold voltage, reverse breakdown occurs in the diode D1 due to PN junction between the seventh diffusion region 137 and the N well 120. Accordingly, a reverse current rapidly increases through a diode due to the PN junction between the seventh diffusion region 137 and the N well 120.

The reverse current flows to the eighth diffusion region 138 through vias and the metal interconnections MI11, MI21, and MI12, and the potential of the eighth diffusion region 138 is increased by the reverse current. Therefore, the reverse bias is applied to the trigger diode D2. When the applied reverse bias exceeds the threshold voltage, reverse breakdown occurs in the trigger diode D2. Accordingly, the reverse current flows through the P well 125.

Thereafter, a voltage drop occurs in the internal resistor Rwp by a current flowing in the P well 125. For example, since the trigger diode D2 is turned on by the voltage of the P well 125, the transistor Q2 is turned on. In addition, the current flows through the internal resistance Rnw of the N well 120 to cause voltage drop. When the trigger diode D1 is turned on by the voltage of the N well 120, the transistor Q2 composed of the N well 120, the P well 125, and the third diffusion region 133 is turned on. Accordingly, a current flows through the transistor Q2.

A voltage drop occurs in the internal resistance Rnw due to the current flowing through the transistor Q2. For example, when the voltage of the N well 120 turns on the trigger diode D1, the transistor Q1 is turned on. Thereafter, two parasitic transistors Q1 and Q2 provide a base current to maintain a positive feedback operation, so the ESD protection device 100 enters a latch mode. In addition, a current discharge path is formed through the transistors Q1 and Q2 that discharges the ESD current through the second electrode E2.

According to an embodiment, the sum of a first threshold voltage that causes reverse breakdown in the trigger diode D1, and a second threshold voltage that causes reverse breakdown in the trigger diode D2, is less than the value of the threshold voltage that causes a reverse breakdown between the N well 120 and the P well 125. Accordingly, since a thyristor, which is a silicon-controlled rectifier (SCR), that includes the transistors Q1, Q2 is triggered before a reverse breakdown occurs between the N well 120 and the P well 125, the value of the trigger voltage is lowered, and ESD current is effectively discharged.

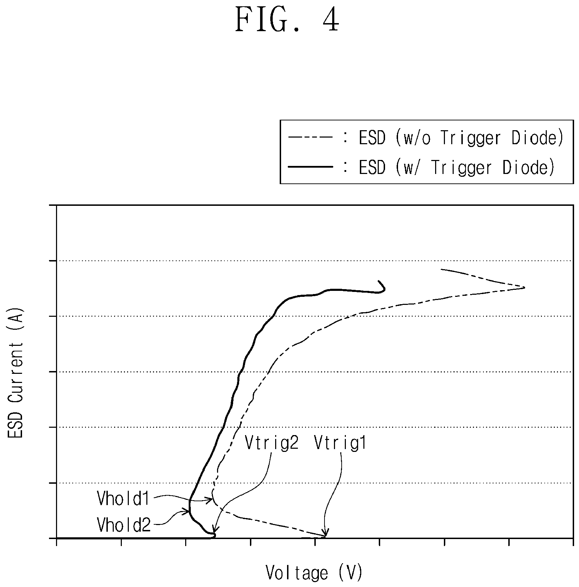

FIG. 4 is a graph that illustrates current-voltage curves of an ESD protection device when trigger diodes are electrically connected to each other according to an embodiment of the present disclosure and an ESD protection device when trigger diodes are not electrically connected to each other.

Referring to FIG. 4, in an ESD protection device in which the trigger diodes are not electrically connected to each other, the trigger voltage is 'Vtrig1', and the holding voltage is 'Vhold1'. In addition, in an ESD protection device in which the trigger diodes are electrically connected to each other, the trigger voltage is 'Vtrig2', and the holding voltage is 'Vhold2'. For example, the trigger voltage is a voltage right before a parasitic NPN transistor, such as Q2 of FIG. 2, in the ESD protection device is turned on. In addition, the holding voltage is the lowest voltage when forming a negative resistance section, such as a snapback section, in which a high voltage is no longer maintained and the voltage decreases after the parasitic NPN transistor operates.

As illustrated in the graph, when the trigger diodes are not electrically connected to each other, the thyristor of the ESD protection device is triggered at the higher level Vtrig1 of the trigger voltage. Accordingly, an ESD protection device without trigger diodes, or trigger diodes that are not electrically connected to each other, might not protect the electronic device from the higher ESD voltage.

On the other hand, according to an embodiment of the present disclosure, the ESD protection device 100 in which the trigger diodes are electrically connected to each other uses breakdown in a trigger diode, instead of reverse breakdown between the N well 120 (FIG. 2) and the P well 125 (FIG. 1), which indicates that the thyristor of the ESD protection device 100 is triggered at a lower level Vtrig2 of trigger voltage.

In addition, according to an embodiment of the present disclosure, the trigger voltage of the ESD protection device 100 can be more finely adjusted in various ways, in addition to adjusting the trigger voltage of the ESD protection device 100 using the trigger diodes D1 and D2 electrically connected to each other. Hereinafter, the details thereof will be described with reference to FIGS. 2, 3, and 4.

According to an embodiment, the level of the threshold voltage that causes reverse breakdown in the trigger diode D1 is lowered by increasing the dopant concentration of the seventh diffusion region 137. Accordingly, the level of the trigger voltage of the ESD protection apparatus 100 is decreased. On the other hand, the level of the threshold voltage that causes reverse breakdown in the trigger diode D1 is increased by decreasing the dopant concentration of the seventh diffusion region 137. Accordingly, the level of the trigger voltage of the ESD protection device 100 is increased.

According to an embodiment, the level of the threshold voltage that causes reverse breakdown in the trigger diode D2 is increased by decreasing the dopant concentration of the eighth diffusion region 138. Accordingly, the level of the trigger voltage of the ESD protection device 100 is decreased. On the other hand, the level of the threshold voltage that causes reverse breakdown in the trigger diode D2 is increased by decreasing the dopant concentration of the eighth diffusion region 138. Accordingly, the level of the trigger voltage of the ESD protection device 100 is increased.

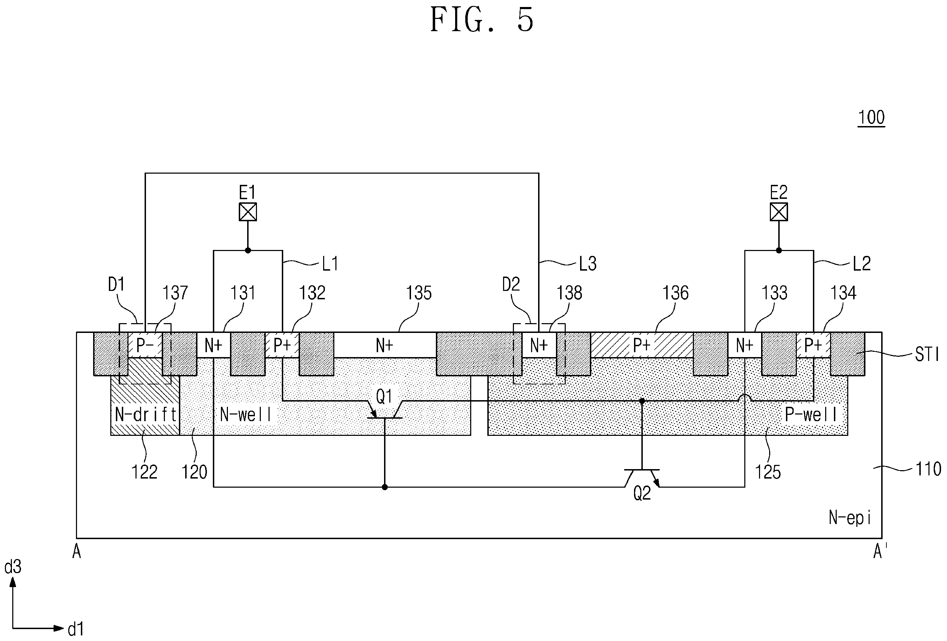

FIG. 5 is a cross-sectional view taken along line A-A' of an ESD protection device of FIG. 1.

For simplicity of illustration, the metal interconnections MI11 and MI12 and vias illustrated in FIG. 2 are not illustrated. Instead, a line L3 is illustrated that indicates that the trigger diodes D1 and D2 are electrically connected to each other. Similarly, a line L1 is illustrated that shows that the first diffusion region 131 and the second diffusion region 132 are electrically connected to each other, , and a line L2 is illustrated that shows that the third diffusion region 133 and the fourth diffusion region 134 are electrically connected to each other.

The ESD protection device 100 includes the substrate 110 that includes the N well 120, an N well 122, and the P well 125 formed thereon. For example, the substrate 110 is an N type epitaxial layer with a low dopant concentration, but embodiments of the present disclosure are not necessarily limited thereto. For example, the N well 122 is doped at a lower concentration than the N well 120, and may be referred to as an N drift region.

The diffusion regions 131 and 135 doped with N type dopants and diffusion regions 132 doped with P type dopants are formed on the N well 120. The N well 122 is adjacent to the N well 120, and the seventh diffusion region 137 is formed on the N well 122. For example, the seventh diffusion region 137 is doped at a concentration lower than the other diffusion regions. The diffusion regions 133 and 138 doped with N type dopants and the diffusion regions 134 and 136 doped with P type dopants are formed on the P well 125.

The trigger diode D1 is formed by a PN junction between the seventh diffusion region 137 and the N well 122, and the trigger diode D2 is formed by a PN junction between the P well 125 and the eighth diffusion region 138. The trigger diodes D1 and D2 are electrically connected to each other by line L3.

According to an embodiment, since the dopant concentration of the N well 122 and the dopant concentration of the seventh diffusion region 137 are relatively low, the value of the threshold voltage that causes reverse breakdown in the trigger diode D1 is greater than the value of the threshold voltage that causes reverse breakdown in the trigger diode D2. Accordingly, the value of the trigger voltage that triggers the thyristor of the ESD protection device 100 is greater than the value of the trigger voltage of the ESD protection device 100 in FIG. 2. For example, the value of the trigger voltage of the ESD protection device 100 of FIG. 5 is greater than the value of 'Vtrig2' of FIG. 4 and less than the value of ` Vtrig 1' .

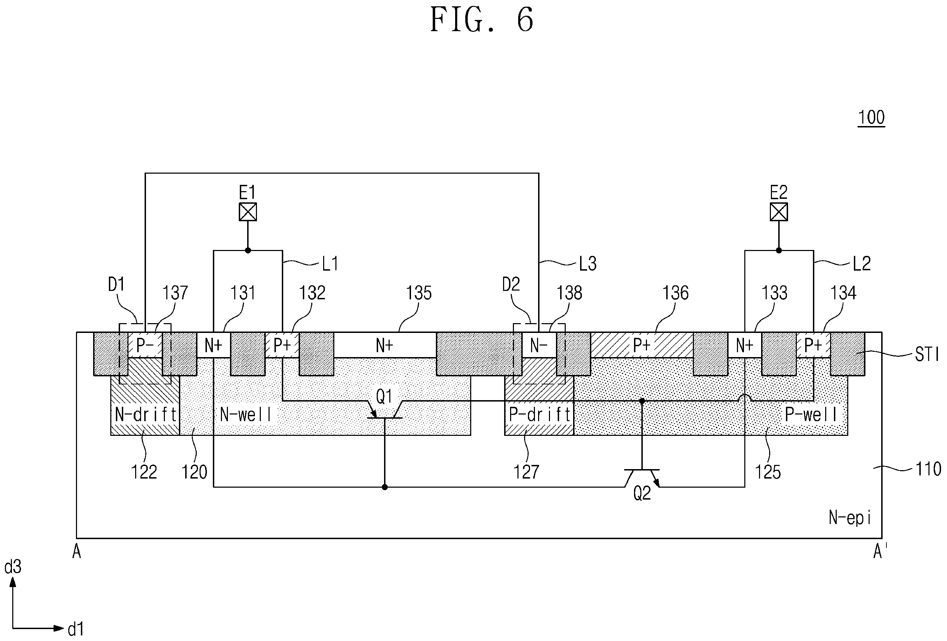

FIG. 6 is a cross-sectional view taken along line A-A' of the ESD protection device of FIG. 1.

Referring to FIG. 6, in an embodiment, the ESD protection device 100 includes the substrate 110 that includes the N well 120, the N well 122, the P well 125, and a P well 127 formed thereon. For example, the substrate 110 is an N type epitaxial layer having a low dopant concentration, but embodiments of the present disclosure are not necessarily limited thereto. For example, the N well 122 is doped at a lower concentration than that N well 120, and may be referred to as an N drift region. For example, the P well 127 is doped at a lower concentration than the P well 125, and may be referred to as a P drift region.

The diffusion regions 131 and 135 doped with N type dopants and the second diffusion region 132 doped with P type dopants are formed on the N well 120. The N well 122 is adjacent to the N well 120, and the seventh diffusion region 137 is formed on the N well 122. For example, the seventh diffusion region 137 is doped at a concentration lower than the other diffusion regions. A diffusion region 133 doped with N type dopants and diffusion regions 134 and 136 doped with P type dopants are formed on the P well 125. The P well 127 is adjacent to the P well 125, and the eighth diffusion region 138 is formed on the P well 127. For example, the eighth diffusion region 138 is doped at a concentration lower than the other diffusion regions.

The trigger diode D1 is formed by a PN junction between the seventh diffusion region 137 and the N well 122, and the trigger diode D2 is formed by a PN junction between the P well 127 and the eighth diffusion region 138. The trigger diodes D1 and D2 are electrically connected to each other by line L3. Although FIG. 6 illustrates the line L3 for simplicity of illustration, the line L3 can be implemented by at least one metal interconnection and/or at least one via as illustrated in FIG. 2 described above.

According to an embodiment, since the dopant concentration of the N well 122 and the dopant concentration of the seventh diffusion region 137 are relatively low, the value of the threshold voltage that causes reverse breakdown in the trigger diode D1 is less than the value of the threshold voltage that causes reverse breakdown in the trigger diode D2 of an embodiment of FIG. 5. In addition, since the dopant concentration of the P well 127 and the dopant concentration of the eighth diffusion region 138 are relatively low, the value of the threshold voltage that causes reverse breakdown in the trigger diode D2 is lower than the value of the threshold voltage that causes reverse breakdown in the trigger diode D2 of an embodiment of FIG. 5.

Accordingly, the value of the trigger voltage that triggers the thyristor of the ESD protection device 100 is greater than the value of the trigger voltage of the ESD protection device 100 in FIG. 5, and less than the value of 'Vtrig1' of FIG. 4.

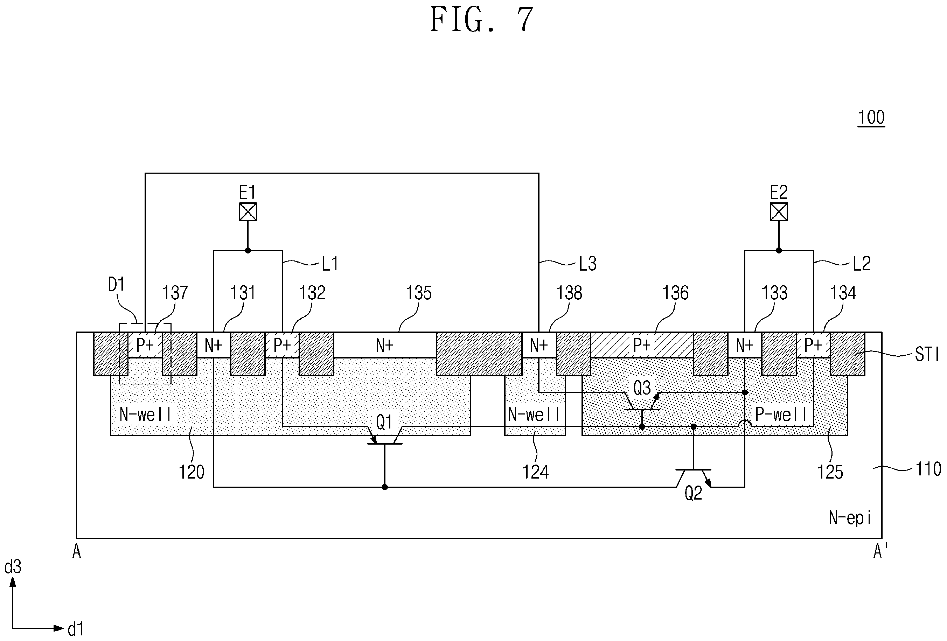

FIG. 7 is a cross-sectional view taken along line A-A' of the ESD protection device 100 of FIG. 1.

Referring to FIGS. 1 and 7, in an embodiment, the ESD protection device 100 includes the substrate 110, the N well 120, an N well 124, the P well 125, the first diffusion region 131, the second diffusion region 132, the third diffusion region 133, the fifth diffusion region 135, the sixth diffusion region 136, the seventh diffusion region 137, the eighth diffusion region 138, and metal interconnections that electrically connect the seventh diffusion region 137 to the eighth diffusion region 138. Although FIG. 7 illustrates the line L3 for simplicity of illustration, the line L3 can be implemented by at least one metal interconnection and/or at least one via as illustrated in FIG. 2.

The substrate 110 is an N type epitaxial layer (N-epi) that has a low dopant concentration. For example, the epitaxial layer is formed on a separate substrate doped with P type dopants or N type dopants. In an embodiment, the substrate 110 is doped with P type dopants at a lower concentration.

The N well 120, the N well 124, and the P well 125 are formed on the substrate 110. The N well 120, the N well 124, and the P well 125 extend in the second direction d2 and are spaced apart from each other in the first direction d1. The N well 120 and the N well 124 are doped with N dopants at a low concentration, and the P well 125 is doped with P dopants at a low concentration. For example, the dopant concentration of the N well 120, the dopant concentration of the N well 124, and the dopant concentration of the P well 125 are lower than the dopant concentration of the substrate 110.

The first diffusion region 131 and the fifth diffusion region 135 doped with N type dopants are formed on the N well 120, and the second diffusion region 132 and the seventh diffusion region 137 doped with P type dopants are formed on the N well 120. The dopant concentration of the diffusion regions 137, 131, 132, and 135 is higher than the dopant concentration of the N well 120.

The first diffusion region 131 and the second diffusion region 132 are formed on the N well 120. The diffusion regions 137, 131, 132, and 135 extend in the second direction d2 and are spaced apart from each other in the first direction d1. The diffusion regions 137, 131, 132, and 135 are electrically isolated from each other by a shallow trench isolation (STI) layer.

The eighth diffusion region 138 doped with N type dopants is formed on the N well 124. For example, the dopant concentration of the eighth diffusion region 138 is higher than the dopant concentration of the N well 124.

The third diffusion region 133 doped with N type dopants is formed on the P well 125, and diffusion regions 134 and 136 doped with P type dopants are formed on the P well 125. The dopant concentration of the diffusion regions 133, 134, and 136 is higher than the dopant concentration of the P well 125.

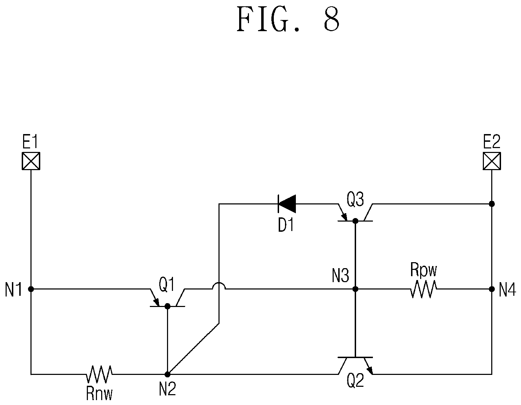

FIG. 8 is an equivalent circuit diagram of the ESD protection device 100 of FIG. 7.

Referring to FIGS. 7 and 8, in an embodiment, the second diffusion region 132, the N well 120, and the P well 125 constitute the PNP transistor Q1, the N well 120, the P well 125, and the third diffusion region 133 constitute an NPN transistor Q2, and the N well 124, the P well 125, and the third diffusion region 133 constitute an NPN transistor Q3. In addition, the seventh diffusion region 137 and the N well 120 constitute the trigger diode D1. In addition, the trigger diode D1 and the eighth diffusion region 138 are electrically connected to each other by the line L3.

An operation of the ESD protection device 100 will be described below with reference to FIGS. 7 and 8 on the assumption that the trigger diode D1 of an embodiment of the present disclosure is not electrically connected to the eighth diffusion region 138.

When an ESD voltage is received through the first electrode E1, the potential of the N well 120 increases. Accordingly, the N well 120 and the P well 125 become reverse-biased, so a depletion region is formed. When the electric field formed in the depletion region exceeds a threshold value as an ESD current continues to be received, reverse breakdown occurs between the N well 120 and the P well 125. For example, the N well 120 is spaced apart from the P well 125 due to the presence of the N well 124. Accordingly, the trigger voltage that triggers the thyristor of the ESD protection device 100 has a higher value. In addition, an electron-hole pair (EHP) is generated within the depletion region, and a hole current is generated by the generated carriers EHPs).

The hole current first flows through the internal resistance Rwp of the P well 125 and causes a voltage drop. When the voltage of the P well 125 turns on the diode due to the PN junction between the P well 125 and the third diffusion region 133, the transistors Q2 and Q3 are turned on. In addition, the hole current flows through the internal resistance Rnw of the N well 120 and causes a voltage drop. For example, when the voltage of the N well 120 turns on the diode due to the PN junction between the second diffusion region 132 and the N well 120, the transistor Q1 is turned on.

For example, three parasitic transistors Q1, Q2, and Q3 provide a base current to each other and maintain a positive feedback operation, such that the ESD protection device 100 enters a latch mode. A current discharge path is formed through the transistors Q1, Q2, and Q3 in the latch mode of the ESD protection device 100, such that the ESD current received through the first electrode E1 is discharged through the second electrode E2.

The operation of the ESD protection device 100 when the trigger diode D1 is electrically connected to the eighth diffusion region 138 will be described with reference to FIGS. 7 and 8.

When an ESD voltage is received through the first electrode E1, the potential of the N well 120 increases. Therefore, a reverse bias is applied to the trigger diode D1 due to the increased potential. When the applied reverse bias exceeds the threshold voltage, reverse breakdown occurs at the trigger diode D1. Accordingly, the reverse current rapidly increases through the trigger diode D1.

The reverse current flows to the N well 124 through the line L3 that electrically connects the trigger diode D1 and the eighth diffusion region 138, and the potential of the N well 124 is increased by the reverse current. Accordingly, the N well 124 and the P well 125 are depleted to form a depletion region. When the electric field formed in the depletion region exceeds a threshold value as a reverse current continues to be received, reverse breakdown occurs between the N well 124 and the P well 125. Thereafter, a charge-hole pair (i.e., a carrier) is formed in the depletion region, and a hole current is generated by the carrier.

A voltage drop occurs in the internal resistance Rwp by a hole current flowing through the N well 124 and the P well 125. When the diode from the PN junction between the P well 125 and the third diffusion region 133 is turned on by the voltage of the P well 125, the transistors Q2 and Q3 are turned on. In addition, the current flows through the internal resistance Rnw of the N well 120 and causes a voltage drop. When the diode from the PN junction between the second diffusion region 132 and the N well 120 is turned on by the voltage of the N well 120, the transistor Q1 formed by the first diffusion region 131, the N well 120, and the P well 125 is turned on.

Accordingly, the ESD protection device 100 enters a latch mode, a current discharge path is formed through the transistors Q1, Q2, and Q3, and the ESD current received through the first electrode E1 is discharged through the second electrode E2.

According to an embodiment, reverse breakdown does not occur between the N well 120, in which the first electrode E1 that receives the input of the ESD current is formed, and the P well 125, in which the second electrode E2 that discharges the ESD current is formed. Instead, the thyristor of the ESD protection device 100 is triggered by a reverse breakdown at the trigger diode D1 and a reverse breakdown between the N well 124, to which the trigger diode D1 is connected, and the P well 125. Accordingly, the level of the trigger voltage is lowered, as compared to when the thyristor is triggered by the reverse breakdown between the N well 120 and the P well 125.

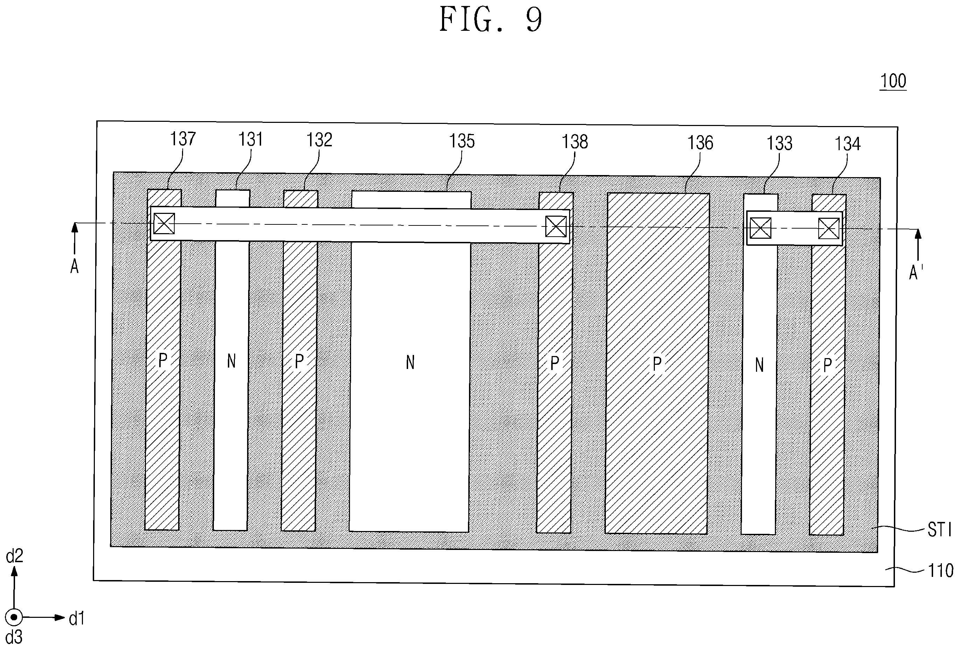

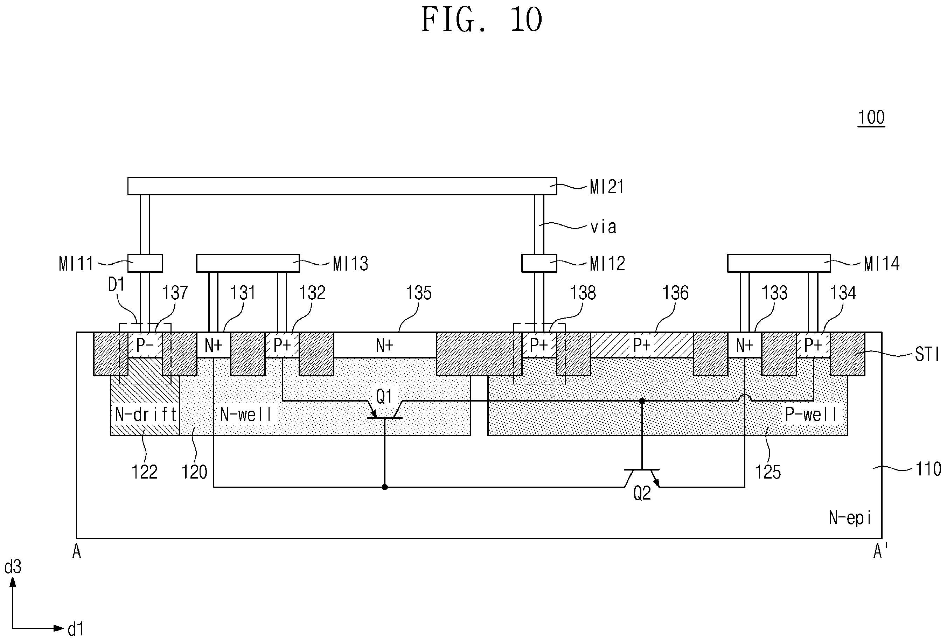

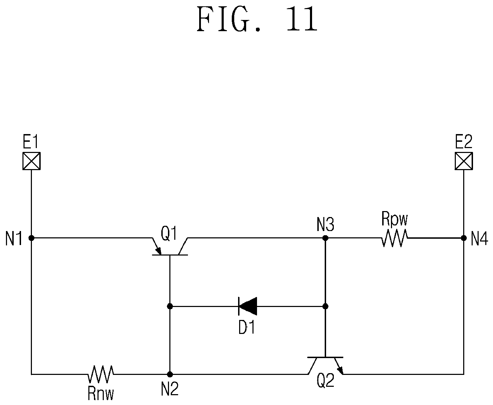

FIG. 9 is a plan view of the ESD protection device 100 according to an embodiment of the present disclosure. FIG. 10 is a cross-sectional view taken along line A-A' of the ESD protection device 100 of FIG. 9. FIG. 11 is an equivalent circuit diagram of the ESD protection device 100 of FIG. 10.

Referring to FIGS. 9 and 10, in an embodiment, the ESD protection device 100 includes the substrate 110 with the N well 120, the N well 122, and the P well 125. The substrate 110 is an N type epitaxial layer that has a low dopant concentration, but embodiments of the present disclosure are not necessarily limited thereto. For example, the substrate 110 is a P type epitaxial layer. For example, the N well 122 is an N drift region doped at a lower concentration than the N well 120.

The diffusion regions 131 and 135 doped with N type dopants and the diffusion region 132 doped with P type dopants are formed on the N well 120. The N well 122 is adjacent to the N well 120, and the seventh diffusion region 137 is formed on the N well 122. For example, the seventh diffusion region 137 is doped at a concentration lower than the other diffusion regions. The diffusion region 133 doped with N type dopants and the diffusion regions 134 and 136 doped with P type dopants are formed on the P well 125.

The trigger diode D1 is formed by PN junction between the seventh diffusion region 137 and the N well 122. The seventh diffusion region 137 of the trigger diode D1 is electrically connected to the eighth diffusion region 138 by the metal interconnections MI11, MI12, and MI21 and vias.

Referring to FIG. 11, in an embodiment, the ESD protection device 100 has an operation similar to that of an ESD protection device illustrated in FIGS. 2 and 3, except for including one trigger diode D1. For example, since reverse breakdown does not occur between the N well 120 and the P well 125, and reverse breakdown occurs in the trigger diode D1, the level of the trigger voltage of the thyristor of the ESD protection device 100 is lower than the level of the trigger voltage of a thyristor of FIG. 2.

However, since the dopant concentration of the N well 122 is lower than the N well 120, and the dopant concentration of the seventh diffusion region 137 is lower than the other diffusion regions, the threshold voltage that causes reverse breakdown in trigger diode D1 is greater than the threshold voltage that causes reverse breakdown in the trigger diode D1 of FIG. 2.

Furthermore, since the junction of the P well 125 and the eighth diffusion region 138 does not form a diode, the trigger voltage that triggers the thyristor of the ESD protection device 100 depends on the dopant concentration of the N well 122 and the seventh diffusion region 137 that form the trigger diode D1. Accordingly, the trigger voltage of the ESD protection device 100 is lower than 'Vtrig1' of FIG. 4.

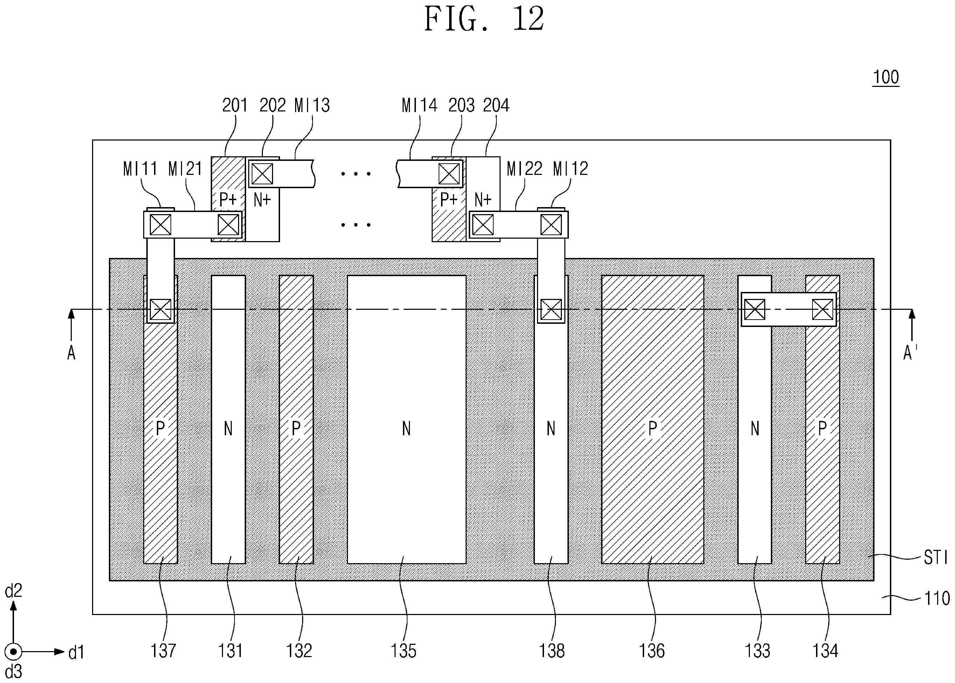

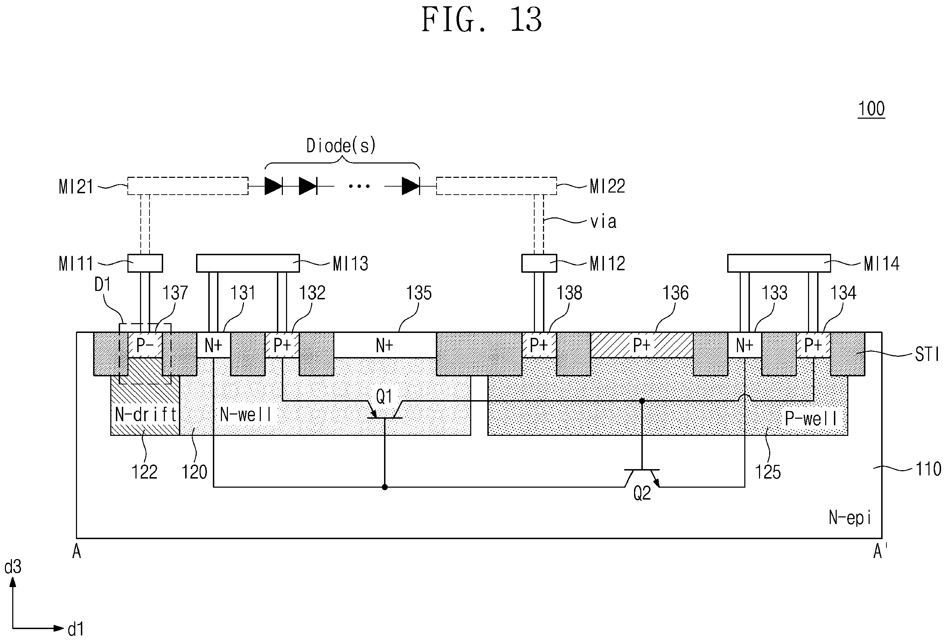

FIG. 12 is a plan view of the ESD protection device 100 according to an embodiment of the present disclosure. FIG. 13 is a cross-sectional view taken along line A-A' of the ESD protection device 100 of FIG. 12.

For simplicity of illustration, metal interconnections MI21 and MI22 and vias not illustrated in the cross-sectional view along the A-A' line are illustrated in the form of dotted lines, and diodes connected in series are illustrated as symbols.

Referring to FIGS. 12 and 13, in an embodiment, the ESD protection device 100 includes the substrate 110 having the N well 120, the N well 122, and the P well 125. The substrate 110 is an N type epitaxial layer that has a low dopant concentration, but embodiments of the present disclosure are not necessarily limited thereto. For example, the substrate 110 is a P type epitaxial layer. For example, the N well 122 is an N drift region doped at a lower concentration than the N well 120.

The diffusion regions 131 and 135 doped with N type dopants and the diffusion region 132 doped with P type dopants are formed on the N well 120. The N well 122 is adjacent to the N well 120, and the seventh diffusion region 137 is formed on the N well 122. For example, the seventh diffusion region 137 is doped at a concentration lower than the other diffusion regions. The diffusion region 133 doped with N type dopants and the diffusion regions 134 and 136 doped with P type dopants are formed on the P well 125.

The trigger diode D1 is formed by PN junction between the seventh diffusion region 137 and the N well 122. The seventh diffusion region 137 of the trigger diode D1 is electrically connected to the eighth diffusion region 138 through the metal interconnections MI11, MI12, MI21, MI22, vias, and at least one forward diode.

Diodes connected in series in the forward direction are formed on the substrate 110. For example, a P type diffusion region 201 that extends in the second direction d2 is formed on the substrate 110. An N type diffusion region 202 that extends in the second direction d2 and is adjacent to the P type diffusion region 201 in the first direction d1 is formed on the substrate 110. The P type diffusion region 201 is electrically connected to the seventh diffusion region 137 through metal interconnections MI11 and MI21 and vias. The N type diffusion region 202 is electrically connected to an adjacent P type diffusion region through a metal interconnection MI13 and a via.

Similarly, a P type diffusion region 203 that extends in the second direction d2 is formed on the substrate 110. An N type diffusion region 204 that extends in the second direction D2 and is adjacent to the P type diffusion region 203 in the first direction d1 is formed on the substrate 110. The P type diffusion region 203 is electrically connected to an adjacent P type diffusion region through a metal interconnection MI14 and vias. The N type diffusion region 204 is electrically connected to the N type diffusion region 138 through a metal interconnection MI12 and a via.

However, a configuration in which forward diodes connected in series are formed is not necessarily limited to the above description. For example, in other embodiments, the arrangement of the diffusion regions 201, 202, 203, and 204 differs from that illustrated in FIG. 12, and the configuration/arrangement of the metal interconnections and vias for electrical connection differ from those illustrated in FIG. 12. In addition, according to an embodiment, the diffusion regions 201, 202, 203, and 204 are not formed on the substrate 110. For example, the series-connected forward diodes are formed on another substrate provided on the substrate 110.

According to an embodiment, the ESD protection device 100 has an operation substantially similar to an operation of the ESD protection device illustrated in FIG. 10, except for including a plurality of forward diodes connected in series. For example, since reverse breakdown occurs in the trigger diode D1 instead of between the P well 120 and the N well 125, the level of the trigger voltage of the thyristor of the ESD protection device 100 is lower than the level of the trigger voltage of a thyristor of FIG. 2. However, since a specific voltage value is required to turn on the series-connected forward diodes, the level of the trigger voltage of a thyristor of the ESD protection device 100 is higher than the level of the trigger voltage in FIG. 10.

In addition, according to an embodiment of FIG. 13, although the level of the trigger voltage is adjusted by a voltage drop that occurs in the diodes, the level of the trigger voltage can be adjusted by a voltage drop that occurs in the transistors. For example, the diodes in FIG. 13 can be replaced with one or more BJTs, and the trigger voltage can be adjusted by using the voltage drop that occurs in the PN junction of the BJT, which is similar to that of FIG. 13. In addition, an FET can be used instead of a BJT.

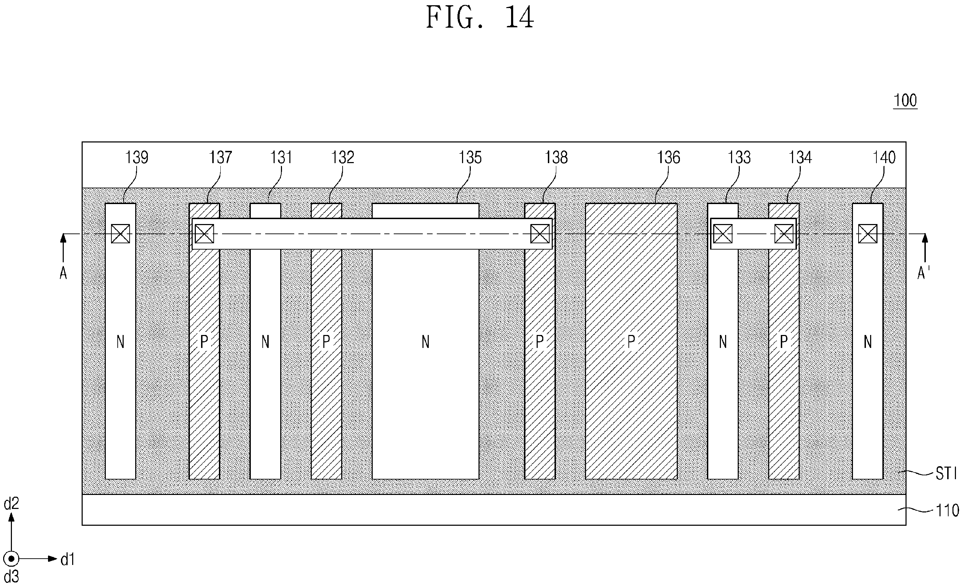

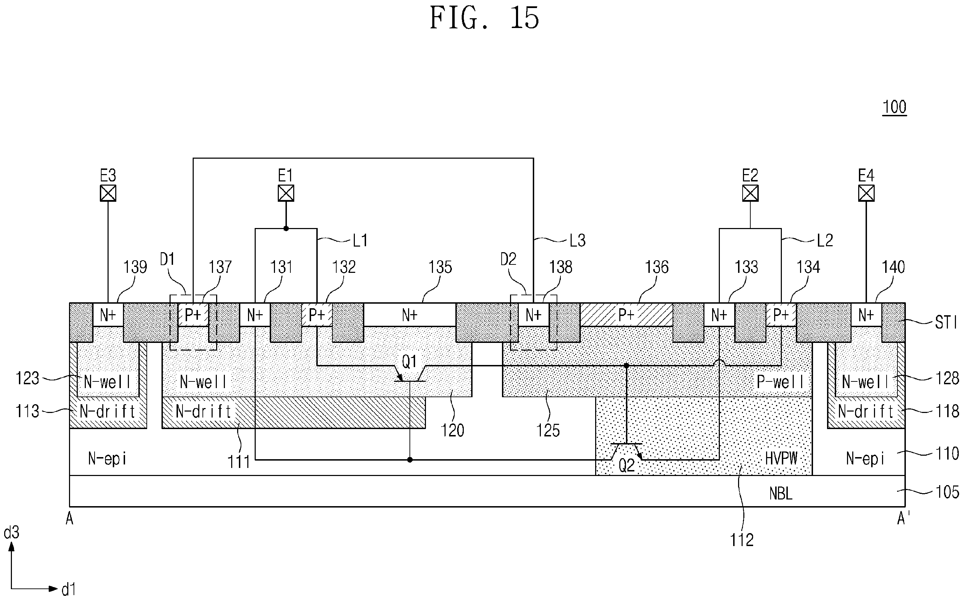

FIG. 14 is a plan view of the ESD protection device 100 according to an embodiment of the present disclosure. FIG. 15 is a cross-sectional view taken along line A-A' of the ESD protection device 100 of FIG. 14.

For simplicity of illustration, metal interconnections and vias connected to diffusion regions are not illustrated in the cross-sectional view of FIG. 15, but are instead represented by lines L1, L2, and L3.

Referring to FIGS. 14 and 15, in an embodiment, the ESD protection device 100 includes a substrate that includes an N type buried layer 105 and an N type epitaxial layer 110 formed thereon. The dopant concentration of the N type buried layer 105 is lower than the dopant concentration of the N type epitaxial layer 110.

An N well 111 and a P well 112 are formed in the N type epitaxial layer 110. The N well 120 is formed on the N well 111, and the P well 125 is formed on the P well 112. For example, the dopant concentration of the N well 111 is lower than the dopant concentration of the N well 120, and the N well 111 is an N drift layer. In addition, the dopant concentration of the P well 112 is lower than the dopant concentration of the P well 125, and the P well 112 is a high voltage well (HVPW).

An N well 113 is formed on the N type epitaxial layer 110, and an N well 123 is formed on the N well 113. For example, the dopant concentration of the N well 113 is lower than the dopant concentration of the N well 123, and the N well 113 is an N drift layer. An N well 118 is formed on the N type epitaxial layer 110, and an N well 128 is formed on the N well 118. For example, the dopant concentration of the N well 118 is lower than the dopant concentration of the N well 128, and the N well 118 is an N drift layer.

As described above, N wells that have mutually different dopant concentrations and P wells that have mutually different dopant concentrations are formed while forming layers. Accordingly, when an ESD current that has a high voltage level is received by the electrode E1, the ESD current can be efficiently discharged through the electrode E2 without leaking.

The diffusion regions 131 and 135 doped with N type dopants and the diffusion regions 132 and 137 doped with P type dopants are formed on the N well 120. The diffusion regions 133 and 138 doped with N type dopants and the diffusion regions 134 and 136 doped with P type dopants are formed on the P well 125. A diffusion region 139 doped with N type dopants is formed on the N well 123, and a diffusion region 140 doped with N type dopants is formed on the N well 128.

The trigger diode D1 is formed through a PN junction between the seventh diffusion region 137 and the N well 120, and the trigger diode D2 is formed by a PN junction between the P well 125 and the eighth diffusion region 138. The trigger diodes D1 and D2 are electrically connected to each other through a line L3.

An operation of the ESD protection device 100 illustrated in FIG. 15 is substantially similar to an operation of an ESD protection device illustrated in FIG. 2. For example, as a reverse breakdown occurs at the trigger diodes D1 and D2, instead of occurring between the N well 120 and the P well 125, the level of the trigger voltage decreases, which is similar to that described with reference to FIG. 2.

However, according to the present embodiment, a higher voltage can be applied to the diffusion regions 139 and 140 through electrodes E3 and E4. Accordingly, the N well 113, the N well 123, and the N type diffusion region 139 operate as a first isolator, and the N well 118, the N well 128, and the N type diffusion region 140 operate as a second isolator. Accordingly, when the ESD protection device 100 operates, the ESD current received by the terminal E1 can be discharged to the terminal E2 without leaking.

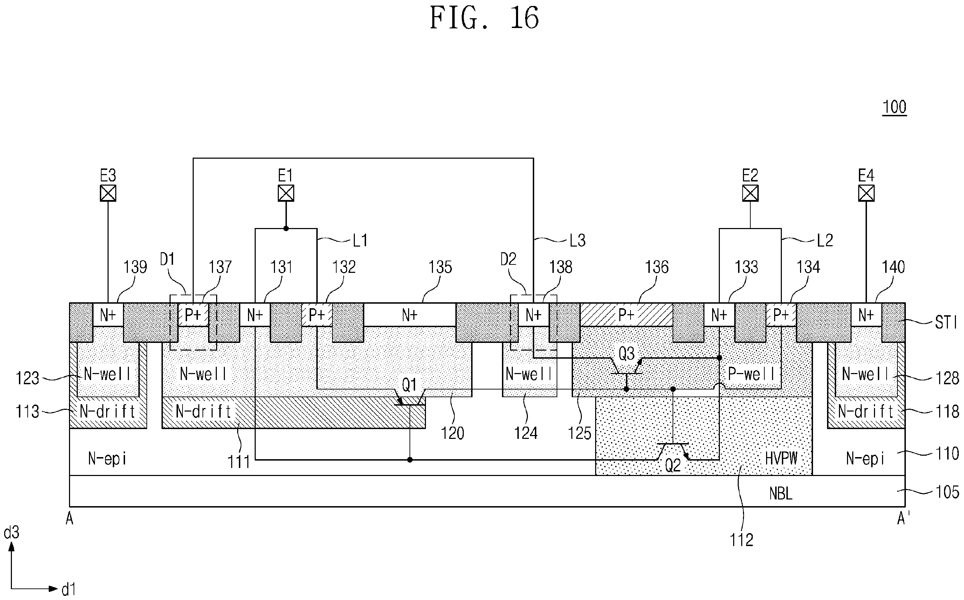

FIG. 16 is a cross-sectional view taken along line A-A' of the ESD protection device 100 of FIG. 14.

For simplicity of illustration, metal interconnections and vias connected to diffusion regions are not illustrated in the cross-sectional view of FIG. 15, but are instead represented by lines L1, L2, and L3.

Referring to FIGS. 14 and 16, in an embodiment, the ESD protection device 100 includes a substrate that has an N type buried layer 105 and an N type epitaxial layer 110 formed thereon. The dopant concentration of the N type buried layer 105 is lower than the dopant concentration of the N type epitaxial layer 110.

The N well 111 and the P well 112 are formed in the N type epitaxial layer 110. The N well 120 is formed on the N well 111, and the P well 125 is formed on the P well 112. In addition, an N well 124 is formed on the N type epitaxial layer 110 between the N well 120 and the P well 125. For example, the dopant concentration of the N well 111 is lower than the dopant concentration of the N well 120, and the N well 111 is an N drift layer. In addition, the dopant concentration of the P well 112 is lower than the dopant concentration of the P well 125, and the P well 112 is a high voltage well (HVPW).

An N well 113 is formed on the N type epitaxial layer 110, and an N well 123 is formed on the N well 113. For example, the dopant concentration of the N well 113 is lower than the dopant concentration of the N well 123, and the N well 113 is an N drift layer. An N well 118 is formed on the N type epitaxial layer 110, and an N well 128 is formed on the N well 118. For example, the dopant concentration of the N well 118 is lower than the dopant concentration of the N well 128, and the N well 118 is an N drift layer.

The diffusion regions 131 and 135 doped with N type dopants and the diffusion regions 132 and 137 doped with P type dopants are formed on the N well 120. The eighth diffusion region 138 doped with the N type dopants is formed on the N well 124. The third diffusion region 133 doped with the N type dopants and the diffusion regions 134 and 136 doped with P type dopants are formed on the P well 125. A diffusion region 139 doped with N type dopants is formed on the N well 123, and a diffusion region 140 doped with the N type dopants is formed on the N well 128.

The trigger diode D1 is formed through PN junction between the seventh diffusion region 137 and the N well 120. The trigger diode D1 is electrically connected to the eighth diffusion region 138 through the line L3.

An operation of the ESD protection device 100 illustrated in FIG. 16 is substantially similar to an operation of the ESD protection device illustrated in FIG. 7. For example, as a reverse breakdown occurs at the trigger diode D1 and between the N well 124 and the P well 125, instead of occurring between the N well 120 and the P well 125, a level of the trigger voltage decreases, which is similar to that described with reference to FIG. 7. However, as a higher voltage is applied to the diffusion regions 139 and 140 through the electrodes E3 and E4, the N well 113, the N well 123, and the N type diffusion region 139 operate as a first isolator, and the N well 118, the N well 128, and the N type diffusion region 140 operate as a second isolator. Accordingly, when the ESD protection device 100 operates, an ESD current received by the terminal E1 is discharged to the terminal E2 without leaking.

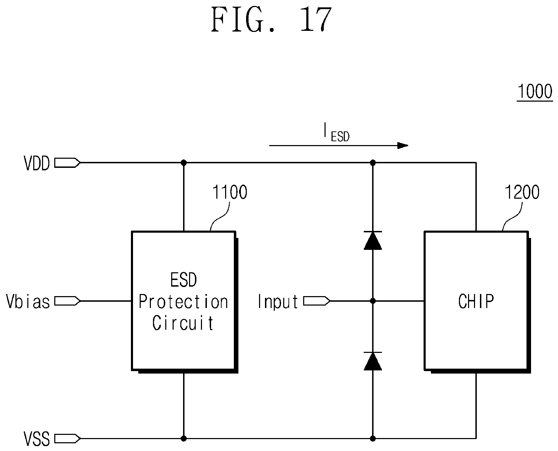

FIG. 17 illustrates an electronic device (or a semiconductor device) 1000 that includes an ESD protection device (or an ESD protection circuit) 1100 according to an embodiment of the present disclosure.

Referring to FIG. 17, in an embodiment, the electronic device 1000 includes an ESD protection device 1100 and a semiconductor chip 1200. A power voltage VDD is supplied to the semiconductor chip 1200 when the semiconductor device 1000 is powered on or operates. For example, an ESD current (I_{ESD}) is generated. As the ESD protection device 1100 operates, the ESD current (I_{ESD}) flows to an electrode supplied with a power supply voltage VSS through the ESD protection device 1100. The ESD protection device 1100 receives an externally supplied separate bias voltage Vbias, and the bias voltage Vbias is provided to the electrodes E3 and E4 to operate the isolator illustrated in FIGS. 15 or 16.

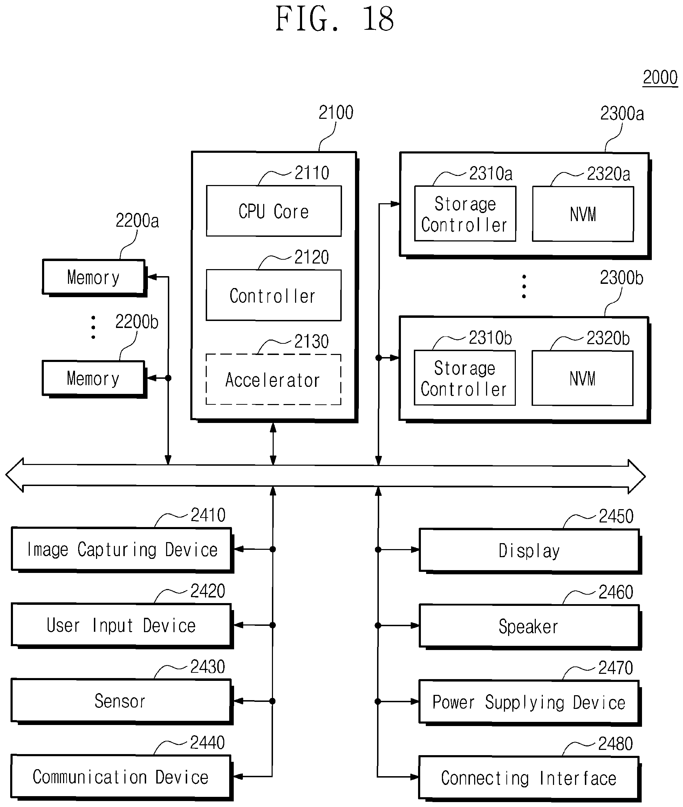

FIG. 18 illustrates a system 2000 that includes an ESD protection device according to an embodiment.

Referring to FIG. 18, in an embodiment, the system 2000 includes a main processor 2100, memories 2200a and 2200b, and storage devices 2300a and 2300b. In addition, the system 2000 includes at least one of an image capturing device 2410, a user input device 2420, a sensor 2430, a communication device 2440, a display 2450, a speaker 2460, a power supplying device 2470, and a connecting interface 2480.

The main processor 2100 controls all operations of the system 2000, specifically, operations of other components included in the system 2000. The main processor 2100 may be implemented as one of a general-purpose processor, a dedicated processor, or an application processor.

The main processor 2100 includes at least one CPU core 2110 and further includes a controller 2120 that controls the memories 2200a and 2200b and/or the storage devices 2300a and 2300b. In some embodiments, the main processor 2100 further includes an accelerator 2130, which is a dedicated circuit for a high-speed data operation, such as an artificial intelligence (AI) data operation. The accelerator 2130 may include at least one of a graphics processing unit (GPU), a neural processing unit (NPU) and/or a data processing unit (DPU), and may be implemented as a chip that is physically separate from the other components of the main processor 2100.

The memories 2200a and 2200b are main memory devices of the system 2000. Although each of the memories 2200a and 2200b may include a volatile memory, such as static random access memory (SRAM) and/or dynamic RAM (DRAM), each of the memories 2200a and 2200b includes non-volatile memory, such as a flash memory, a phase-change RAM (PRAM) and/or a resistive RAM (RRAM). The memories 2200a and 2200b may be implemented in the same package as the main processor 2100.

The storage devices 2300a and 2300b are non-volatile storage devices that store data regardless of whether power is supplied thereto, and have larger storage capacity than the memories 2200a and 2200b. The storage devices 2300a and 2300b respectively include storage controllers (STRG CTRL) 2310a and 2310b and non-volatile memories (NVMs) 2320a and 2320b that store data under the control of the storage controllers 2310a and 2310b. Although the NVMs 2320a and 2320b may include flash memories having a two-dimensional (2D) structure or a three-dimensional (3D) V-NAND structure, the NVMs 2320a and 2320b may also include other types of NVMs, such as PRAM and/or RRAM.

The storage devices 2300a and 2300b may be physically separated from the main processor 2100 and included in the system 2000, or may be implemented in the same package as the main processor 2100. In addition, the storage devices 2300a and 2300b may include solid-state devices (SSDs) or memory cards and be removably combined with other components of the system 2000 through an interface, such as the connecting interface 2480 that will be described below. The storage devices 2300a and 2300b can be operated by a standard protocol, such as a universal flash storage (UFS), an embedded multi-media card (eMMC), or a non-volatile memory express (NVMe), , without necessarily being limited thereto.

The image capturing device 2410 captures still images or moving images. The image capturing device 2410 includes at least one of a camera, a camcorder, or a webcam.

The user input device 2420 receives various types of data input from a user of the system 2000 and includes one or more of a touch pad, a keypad, a keyboard, a mouse, and/or a microphone.

The sensor 2430 can detect various types of externally applied physical quantities, and convert the detected physical quantities into electric signals. The sensor 2430 includes one or more of a temperature sensor, a pressure sensor, an illuminance sensor, a position sensor, an acceleration sensor, a biosensor, and/or a gyroscope sensor.

The communication device 2440 transmits and receives signals between other devices outside the system 2000 according to various communication protocols. The communication device 2440 includes one or more of an antenna, a transceiver, and/or a modem.

The display 2450 and the speaker 2460 are output devices that respectively output visual information and auditory information to the user of the system 2000.

The power supplying device 2470 appropriately converts a power received from a battery embedded in the system 2000 and/or an external power source, and supplies the converted power to each component of the system 2000. For example, the power supplying device 2470 includes at least one power management integrated circuit (PMIC). The power supplying device 2470 includes an ESD protection device described with reference to FIGS. 1 to 16.

The connecting interface 2480 connects the system 2000 with an external device to exchange data with the system 2000. The connecting interface 2480 is implemented with one of various interfaces, such as an Advanced Technology Attachment (ATA) interface, a Serial ATA (SATA) interface, an external SATA (e-SATA) interface, a Small Computer Small Interface (SCSI) interface, a Serial Attached SCSI (SAS) interface, a Peripheral Component Interconnection (PCI) interface, a PCI express (PCIe) interface, an NVM express (NVMe) interface, an IEEE 1394 interface, an Universal Serial Bus (USB) interface, a Secure Digital (SD) card interface, a Multi-Media Card (MMC) interface, an embedded Multi-Media Card (eMMC) interface, a Universal Flash Storage (UFS) interface, an embedded Universal Flash Storage (eUFS) interface, or a Compact Flash (CF) card interface.

According to an embodiment of the present disclosure, a thyristor of an ESD protection device is prevented from being triggered by using reverse breakdown between a well connected to an anode electrode and a well connected to a cathode electrode. Instead, the thyristor of the ESD protection device is triggered using reverse breakdown in at least one trigger diode generated by electrically connecting the wells to each other. Accordingly, the level of the trigger voltage is lowered, thereby effectively protecting an electronic device.

In addition, instead of securing an additional region for forming a trigger diode, the trigger diode is formed using diffusion regions formed on an N well and a P well. Accordingly, the area of an ESD protection device can be reduced.

The above description refers to detailed embodiments for carrying out the present disclosure. Embodiments in which a design is simply changed or which can be easily changed are included in the present disclosure as well as an embodiment described above. In addition, technologies that are easily changed and implemented by using embodiments are included in the present disclosure. While embodiments of the present disclosure have been described with reference to the drawings thereof, it will be apparent to those of ordinary skill in the art that various changes and modifications may be made thereto without departing from the spirit and scope of embodiments of the present disclosure as set forth in the following claims.

## Claims

1. An electro-static discharge (ESD) protection device, comprising:
a substrate that includes a first well that has a first conductive type and a second well that has a second conductive type;
a first diffusion region that has the first conductive type and a second diffusion region that has the second conductive type, wherein the first diffusion region and the second diffusion region are formed on the first well and connected to a first electrode;
a third diffusion region that has the first conductive type and a fourth diffusion region that has the second conductive type, wherein the third diffusion region and the fourth diffusion region are formed on the second well and connected to a second electrode;
a fifth diffusion region that has the first conductive type and that is formed on the first well and is adjacent to the second diffusion region;
a sixth diffusion region that has the second conductive type and that is formed on the second well and is adjacent to the third diffusion region;
a seventh diffusion region that has the second conductive type and that is formed on the first well and is adjacent to the first diffusion region; and
an eighth diffusion region that has the first conductive type and that is formed on the second well and is adjacent to the sixth diffusion region,
wherein the seventh diffusion region and the eighth diffusion region are electrically connected to each other.

2. The ESD protection device of claim 1, wherein the first conductive type is an N conductive type, and the second conductive type is a P conductive type.

3. The ESD protection device of claim 1, further comprising:
at least one metal interconnection and at least one via that electrically connect the seventh diffusion region and the eighth diffusion region.

4. The ESD protection device of claim 1, wherein the substrate includes an epitaxial layer that has the first conductive type.

5. The ESD protection device of claim 1,
wherein the first diffusion region is adjacent to the seventh diffusion region, the second diffusion region is adjacent to the first diffusion region, and the fifth diffusion region is adjacent to the second diffusion region;
wherein the sixth diffusion region is adjacent to the eighth diffusion region, the third diffusion region is adjacent to the sixth diffusion region, and the fourth diffusion region is adjacent to the third diffusion region; and
wherein the fifth diffusion region and the eighth diffusion region are formed adjacent to a boundary between the first well and the second well.

6. The ESD protection device of claim 1,
wherein a portion of the first well in which the seventh diffusion region is formed has a dopant concentration that is lower than a dopant concentration of a remaining portion of the first well, and
wherein the seventh diffusion region has a dopant concentration lower than a dopant concentration of the second diffusion region.

7. The ESD protection device of claim 1, wherein a portion of the second well in which the eighth diffusion region is formed has a dopant concentration that is lower than a dopant concentration of a remaining portion of the second well, and
wherein the eighth diffusion region has a dopant concentration lower than a dopant concentration of the third diffusion region.

8. The ESD protection device of claim 1, further comprising:
a third well that has the first conductive type and that is formed on the substrate;
a fourth well that has the first conductive type and that is formed on the third well;
a ninth diffusion region that has the first conductive type and that is formed on the fourth well;
a fifth well that has the first conductive type and that is formed on the substrate;
a sixth well that has the first conductive type and that is formed on the third well; and
a tenth diffusion region that has the first conductive type and that is formed on the sixth well,
wherein a bias voltage is applied to the ninth diffusion region and the tenth diffusion region.

9. The ESD protection device of claim 8, further comprising:
a seventh well that has the first conductive type and that is formed under the first well inside the substrate; and
an eighth well that has the second conductive type and that is formed under the second well inside the substrate.

10. The ESD protection device of claim 9,
wherein the first well has a dopant concentration that is higher than a dopant concentration of the seventh well, and
wherein the second well has a dopant concentration that is higher than a dopant concentration of the eighth well.

11. The ESD protection device of claim 1, wherein the first electrode is an anode electrode, and the second electrode is a cathode electrode.

12. An electro-static discharge (ESD) protection device, comprising:
a substrate that includes a first well that has a first conductive type, a second well that has the first conductive type, and a third well that has a second conductive type;
a first diffusion region that has the first conductive type and a second diffusion region that has the second conductive type, wherein the first diffusion region and the second diffusion region are formed on the first well and connected to a first electrode;
a third diffusion region that has the first conductive type and a fourth diffusion region that has the second conductive type, wherein the third diffusion region and the fourth diffusion region are formed on the second well and connected to a second electrode;
a fifth diffusion region that has the first conductive type and that is formed on the first well and is adjacent to the second diffusion region;
a sixth diffusion region that has the second conductive type and that is formed on the second well and is adjacent to the third diffusion region;
a seventh diffusion region that has the second conductive type and that is formed on the first well and is adjacent to the first diffusion region; and
an eighth diffusion region that has the first conductive type and that is formed on the third well,
wherein the seventh diffusion region and the eighth diffusion region are electrically connected to each other.

13. The ESD protection device of claim 12, further comprising:
at least one metal interconnection and at least one via that electrically connect the seventh diffusion region and the eighth diffusion region.

14. The ESD protection device of claim 12, wherein the third well is disposed between the first well and the second well.

15. The ESD protection device of claim 12,
wherein the first diffusion region is adjacent to the seventh diffusion region, the second diffusion region is adjacent to the first diffusion region, and the fifth diffusion region is adjacent to the second diffusion region;
wherein the third diffusion region is adjacent to the sixth diffusion region, and the fourth diffusion region is adjacent to the third diffusion region; and
wherein the fifth diffusion region and the eighth diffusion region are formed adjacent to the second well.
